Europäisches Patentamt

European Patent Office

Office européen des brevets

(19)

(11) Veröffentlichungsnummer: **0 122 431**
**A1**

(12) # EUROPÄISCHE PATENTANMELDUNG

(21) Anmeldenummer: **84102450.8**

(22) Anmeldetag: **07.03.84**

(51) Int. Cl.³: **H 01 L 23/04**

(30) Priorität: **11.03.83 DE 3308720**

(43) Veröffentlichungstag der Anmeldung:
**24.10.84 Patentblatt 84/43**

(84) Benannte Vertragsstaaten:
**BE DE FR GB IT SE**

(71) Anmelder: **Siemens Aktiengesellschaft**
**Berlin und München Wittelsbacherplatz 2**
**D-8000 München 2(DE)**

(72) Erfinder: **Vogt, Herbert**
**Wurzerstrasse 18**
**D-8000 München 22(DE)**

(72) Erfinder: **Egerbacher, Werner**
**Vogelhartstrasse 4**
**D-8000 München 40(DE)**

(72) Erfinder: **Wunderlich, Dieter**
**Prof.-Schmid-Strasse 95**
**D-8037 Olching-Geiselbullach(DE)**

(72) Erfinder: **Mitzkus, Werner**
**Vogelhartstrasse 21**
**D-8000 München 40(DE)**

(54) **Halbleiterbauelement mit scheibenförmigem Gehäuse.**

(57) Das scheibenförmige Gehäuse weist einen Isolierstoffbecher (1) mit einer Öffnung (2) im Boden auf. Durch diese Öffnung (2) tritt eine Kontaktfläche (4) einer von zwei plattenförmigen Anschlußkörpern (3), zwischen denen ein druckkontaktierter Halbleiterkörper (14) liegt. Beide Anschlußkörper (3, 5) weisen radial und axial gerichtete Dichtflächen (8, 9; 11, 12) auf, an denen ein elastischer, den Halbleiterkörper umgebender Ring (13) unter Druck anliegt. Der Becher ist mit Vergußmasse (18) gefüllt; der Halbleiterkörper ist damit gegen das Eindringen von Vergußmasse geschützt.

FIG 1

EP 0 122 431 A1

SIEMENS AKTIENGESELLSCHAFT          Unser Zeichen
Berlin und München                  VPA 83 P 1 1 3 4 E

### Halbleiterbauelement mit scheibenförmigem Gehäuse

Die Erfindung bezieht sich auf ein Halbleiterbauelement mit zwei je eine äußere Kontaktfläche aufweisenden rondenförmigen Anschlußkörpern, zwischen denen ein Halbleiterkörper angeordnet ist, mit einem mit Vergußmasse mindestens teilweise gefüllten, aus Isolierstoff bestehenden Becher, mit einer Öffnung am Boden des Bechers, die durch einen der Anschlußkörper verschlossen ist, und bei dem die Vergußmasse den Halbleiterkörper und die Anschlußkörper unter Freilassung der Kontaktflächen umgibt.

Ein solches Halbleiterbauelement ist beispielsweise in der Europäischen Patentanmeldung Nr. 0 034 208 beschrieben worden. Bei diesem Halbleiterbauelement ist der Halbleiterkörper mit den Anschlußkörpern verlötet. Zum Schutz des Halbleiterkörpers gegen die Vergußmasse ist dieser von einem Schutzlack eingehüllt, der den freien Raum zwischen den Anschlußkörpern ausfüllt.

Bei durch Druckkontakt kontaktierten Halbleiterbauelementen ist der Halbleiterkörper mit den Anschlußkörpern nicht verlötet, sondern lose zwischen die Anschlußkörper gelegt. Dabei muß verhindert werden, daß Vergußmasse zwischen die Anschlußkörper und den Halbleiterkörper eindringt. Die Verwendung eines Schutzlackes zwischen dem Halbleiterkörper und der Vergußmasse scheidet hierbei aus, da der Schutzlack selbst die Tendenz hat, die Kontaktflächen zwischen Halbleiterkörper und Anschlußkörpern zu benetzen.

Hab 1 Dx / 08.03.1983

Der Erfindung liegt die Aufgabe zugrunde, ein Halbleiterbauelement der beschriebenen Art so weiterzubilden, daß auch bei Verwendung eines Druckkontaktes das Eindringen von Vergußmasse verhindert wird.

Diese Aufgabe wird dadurch gelöst, daß die Anschlußkörper an ihren einander zugekehrten Seiten am Rand konzentrische Dichtflächen aufweisen, daß zwischen diesen Dichtflächen mindestens ein elastischer Ring sitzt und daß der Ring mindestens stirnseitig unter Druck an den Dichtflächen anliegt.

Weiterbildungen der Erfindung sind Gegenstand der Unteransprüche.

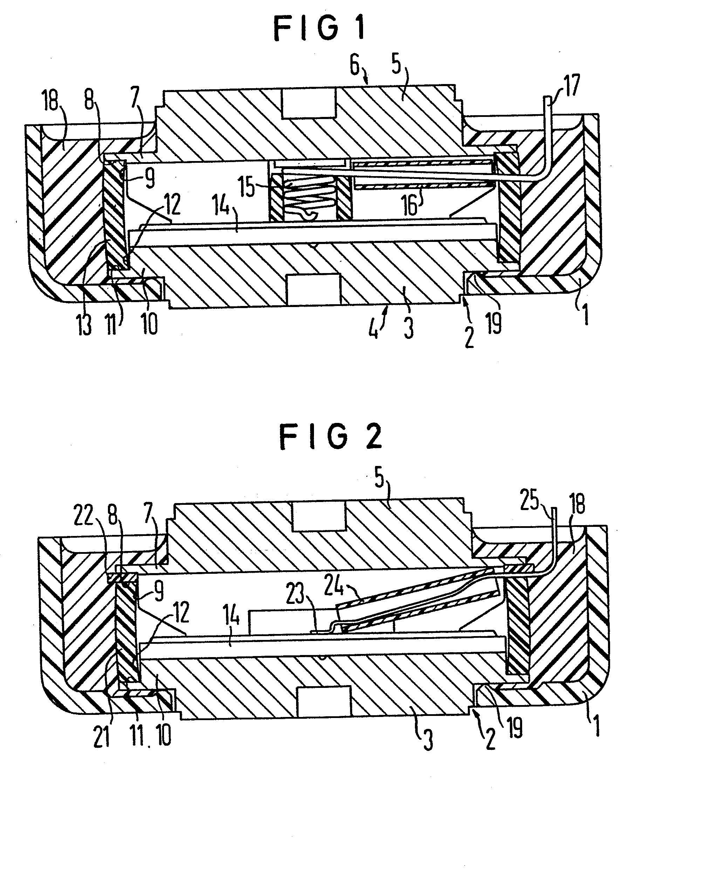

Die Erfindung wird anhand einiger Ausführungsbeispiele in Verbindung mit den Fig. 1 bis 4 näher erläutert. Diese zeigen je einen Schnitt durch vier verschiedene Ausführungsbeispiele.

Das Halbleiterbauelement nach Fig. 1 hat einen Becher 1 aus Isolierstoff, der am Boden mit einer Öffnung 2 versehen ist. Die Öffnung 2 ist durch einen ersten Anschlußkörper 3 verschlossen. Der Anschlußkörper 3 hat eine äußere Kontaktfläche 4, die aus dem Boden des Bechers 1 etwas heraustritt. Sie kann jedoch auch bündig mit dem Boden abschließen. Auf dem Anschlußkörper 3 sitzt ein Halbleiterkörper 14, der beispielsweise aus einer Molybdänronde und einer anlegierten Siliciumscheibe besteht. Auf der Oberseite wird der Halbleiterkörper 14 durch einen zweiten Anschlußkörper 5 mit einer äußeren Kontaktfläche 6 kontaktiert. Diese Kontaktfläche 6 ragt über die Oberkante des Bechers 1 heraus, kann jedoch auch auf gleicher Höhe liegen. Die Anschlußkörper 3, 5 sind mit radialen Schultern 10 bzw. 7 versehen. Die Schultern 7, 10 haben zueinander konzentrische erste Dichtflächen 8, 11 und zweite Dichtflächen 9, 12. Die ersten Dichtflächen 8, 11 haben im Ausführungsbeispiel radiale Richtung, während die Dichtflächen 9, 12 von einer Umfangsfläche der Anschlußkörper gebildet sind. Hier sind die zweiten Dichtflächen axial ausgerichtet. Die Dichtflächen können jedoch auch zur Achse bzw. zum Radius der Anschlußkörper geneigt sein. Erste und zweite Dichtfläche können aber auch eine einzige, z. B. gewölbte Fläche bilden.

An den Dichtflächen 8, 9, 11, 12 liegt ein elastischer, aus Isoliermaterial bestehender Ring 13 an, dessen Höhe in unbelastetem Zustand größer als der Abstand zwischen den Dichtflächen 8 und 11 ist. Beim Aneinanderpressen der Anschlußkörper 3 und 5 wird er daher etwas zusammengedrückt, so daß seine Stirnflächen dicht an den Dichtflächen 8, 11 anliegen. Zur Erleichterung der Montage und Erhöhung der Dichtigkeit kann der elastische Ring 13 auch unter Druck an den Dichtflächen 9, 12 anliegen. Damit ergibt sich eine handhabbare Halbleitereinheit, die vor dem Einsetzen in den Becher 1 zusammengesetzt und elektrisch geprüft werden kann. Die aus den Anschlußkörpern 3, 5, dem elastischen Ring 13 und dem Halbleiterkörper 14 bestehende Einheit wird durch Einfüllen von Vergußmasse 18 in den Becher 1 fest miteinander und mit dem Becher 1 verbunden. Die Verbindung ist dann besonders gut, wenn die Schultern 7, 10 außen von der Vergußmasse bedeckt sind. Beim Eingießen der Vergußmasse 18 muß der Anschlußkörper 3 gegen den Anschlußkörper 5 gedrückt werden, um ein Eindringen von Vergußmasse in das Innere des Ringes zu verhindern. Ein Austreten von Vergußmasse durch die Öffnung 2 wird durch die Wirkung einer die Öffnung 2 umgebenden Dichtlippe 19 verhindert, auf der der Anschlußkörper 3 sitzt. Nach Erstarren der Vergußmasse können die Anschlußkörper 3, 5 wieder entlastet werden. Sie werden nunmehr durch die Vergußmasse 18 zusammengehalten. Zur Inbetriebnahme wird das Halbleiterbauelement zwischen zwei Kühlkörpern eingepreßt, die den notwendigen Kontaktdruck zwischen den Anschlußkörpern und dem Halbleiterkörper aufbringen.

Handelt es sich bei dem Halbleiterkörper 14 um eine Thyristortablette, so ist diese mit einem Steuerkontakt 15 kontaktiert. Dieser kann beispielsweise aus einer gewendelten Feder bestehen, die elektrisch isoliert in einer zentralen Ausnehmung des Anschlußkörpers 5 sitzt. Der Steuerkontakt 15 ist mit einer Steuerleitung 17 verbunden, die beispielsweise durch ein Isolierröhrchen 16 isoliert und in einem Schlitz des Anschlußkörpers 5 angeordnet ist. Die Steuerleitung 17 durchstößt hierbei den Körper des elastischen Ringes 13.

Das Halbleiterbauelement nach Fig. 2 unterscheidet sich von dem nach Fig. 1 im wesentlichen dadurch, daß statt eines einzigen elastischen Ringes zwei zueinander konzentrische elastische Ringe 21, 22 verwendet sind. Diese Ringe liegen mit ihren einander zugekehrten Stirnflächen unter Druck aneinander und dichten ihrerseits durch Anliegen an den Dichtflächen 8, 11 und gegebenenfalls an den Dichtflächen 9, 12 ab. Der erste elastische Ring 21 umfaßt dabei eine als Dichtfläche ausgebildete Umfangsfläche des Anschlußkörpers 3 und einen Teil einer Umfangsfläche des Anschlußkörpers 5. Der zweite elastische Ring 22 hat wesentlich geringere Höhe und umfaßt nur eine Umfangsfläche des Anschlußkörpers 5. Im Ausführungsbeispiel nach Fig. 2 ist dargestellt, daß der Außendurchmesser des elastischen Ringes 22 größer ist als der des elastischen Ringes 21. Beide Außendurchmesser können jedoch auch gleich groß sein. Andererseits können die Innendurchmesser der elastischen Ringe voneinander abweichen.

0122431

Der Halbleiterkörper 14 ist mit einem Steuerkontakt 23 kontaktiert. Dieser ist mit einer in einem Schlitz des Anschlußkörpers 5 verlaufenden Steuerleitung 25 verbunden. Die Steuerleitung 25 geht zwischen den gegenseitig anliegenden Stirnseiten der Ringe 21, 22 nach außen. Zum Vergießen des Bechers 1 werden wieder die Anschlußkörper 3 und 5 gegeneinander gedrückt, wodurch das Eindringen von Vergußmasse sowohl zwischen den Ringen und den Anschlußkörpern als auch an der Stelle des Durchtritts der Steuerleitung 25 vermieden wird.

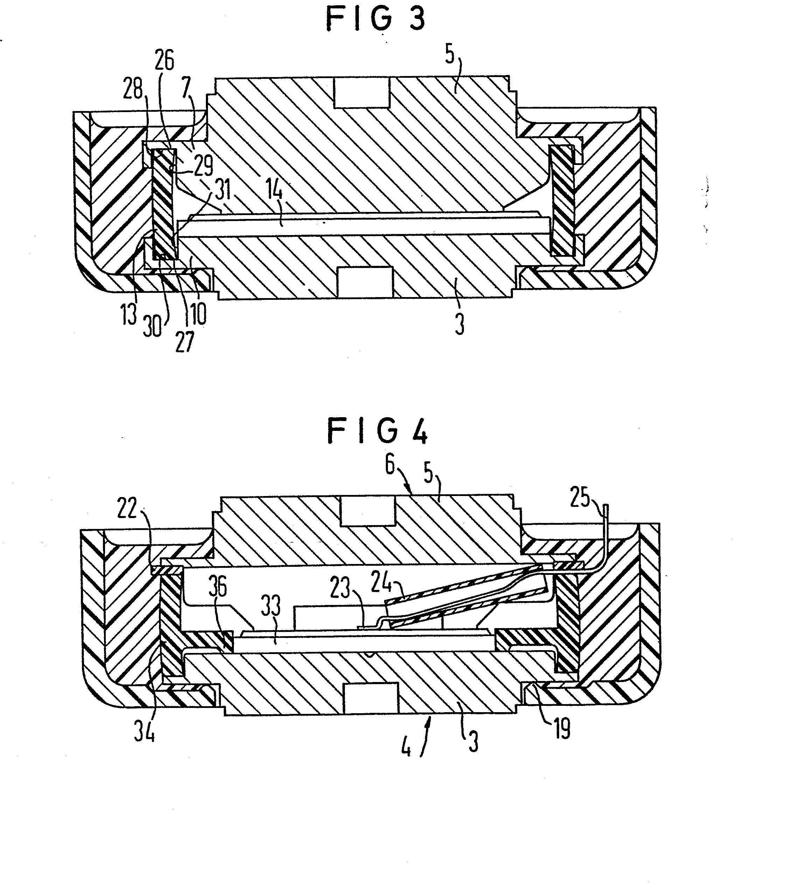

Das Halbleiterbauelement nach Fig. 3 unterscheidet sich von dem nach Fig. 1 im wesentlichen dadurch, daß die Enden des elastischen Ringes 13 in Nuten 26, 27 sitzen, die an den einander zugekehrten Seiten der Schulter 7, 10 angebracht sind. Die Nuten bilden erste Dichtflächen 26 und 27 und am Umfang der Anschlußkörper zweite Dichtflächen 29, 31. Diese Ausführungsform ist eine Kapsel für eine Diodentablette, sie kann jedoch auch eine Thyristortablette kapseln, wobei eine entsprechende Aussparung und ein entsprechender Schlitz wie in den Ausführungsbeispielen nach Fig. 1 und 2 vorzusehen sind.

Die elastischen Ringe nach den Ausführungsbeispielen der Fig. 1 bis 3 sind zylindrisch ausgebildet. Sie zentrieren gleichzeitig den Halbleiterkörper 14 im Inneren des Gehäuses, wenn dessen Außendurchmesser so groß wie der Innendurchmesser des Ringes ist. Ist der Durchmesser des Halbleiterkörpers kleiner als der Innendurchmesser des Ringes, so kann der Ring (34 in Fig. 4) an seiner Innenseite mit einer radial zurückspringenden Schulter 35 versehen sein. Der Ring 34 kann zusammen mit einem zweiten Ring 22 die Abdichtung übernehmen, es kann jedoch auch ein einteiliger Ring mit einer entsprechenden Innenschulter zur Anwendung kommen. Entsprechend können auch bei diesem Ausführungsbeispiel die in Fig. 1 oder in Fig. 2 gezeigten Steuerkontaktierungen verwendet werden. Zur Kapselung einer Diode nach Fig. 3 läßt sich das Ausführungsbeispiel nach Fig. 4 ebenfalls verwenden.

7 Patentansprüche
4 Figuren

Patentansprüche

1. Halbleiterbauelement mit zwei je eine äußere Kontaktfläche aufweisenden rondenförmigen Anschlußkörpern (3,
5), zwischen denen ein Halbleiterkörper (14, 33) angeordnet ist, mit einem mit Vergußmasse (18) mindestens teilweise gefüllten, aus Isolierstoff bestehenden Becher (1),
mit einer Öffnung (2) am Boden des Bechers, die durch
einen der Anschlußkörper (3) verschlossen ist, und bei
dem die Vergußmasse den Halbleiterkörper und die Anschlußkörper unter Freilassung der Kontaktflächen (4, 6)
umgibt, d a d u r c h   g e k e n n z e i c h n e t ,
daß die Anschlußkörper (3, 5) an ihren einander zugekehrten Seiten am Rand konzentrische Dichtflächen (8, 9;
11, 12) aufweisen, daß zwischen diesen Dichtflächen mindestens ein elastischer Ring (13) sitzt und daß der Ring
mindestens stirnseitig unter Druck an den Dichtflächen
anliegt.

2. Halbleiterbauelement nach Anspruch 1, d a d u r c h
g e k e n n z e i c h n e t ,   daß die Dichtfläche (8,
9; 11, 12) auf einer radial vorspringenden Schulter (7,
10) liegt und daß die Schulter teilweise in die Vergußmasse (18) eingebettet ist.

3. Halbleiterbauelement nach Anspruch 1 oder 2,  d a -
d u r c h   g e k e n n z e i c h n e t ,   daß jeder Anschlußkörper (3, 5) eine radiale (8, 11) und eine axiale
Dichtfläche (9, 12) aufweist und daß der Ring (13) unter
Druck an der axialen und der radialen Dichtfläche anliegt.

4. Halbleiterbauelement nach einem der Ansprüche 1 bis 3,
d a d u r c h   g e k e n n z e i c h n e t ,   daß zwischen den Dichtflächen zwei zueinander konzentrische elastische Ringe (21, 22) sitzen, die unter Druck an ihren Stirnflächen aneinander liegen, daß der erste Ring (21) an den axialen Dichtflächen (9, 12) beider Anschlußkörper (3, 5) anliegt, daß der zweite Ring (22) schmaler als der erste Ring ist und nur an der axialen Dichtfläche (9) einer der Anschlußkörper (5) anliegt.

5. Halbleiterbauelement nach einem der Ansprüche 1 bis 3, d a d u r c h   g e k e n n z e i c h n e t ,   daß der Halbleiterkörper (14) mit einer Steuerleitung (17) kontaktiert ist und daß die Steuerleitung durch den Körper des elastischen Ringes (13) hindurchgeht.

6. Halbleiterbauelement nach Anspruch 4, d a d u r c h   g e k e n n z e i c h n e t ,   daß der Halbleiterkörper (14) mit einer Steuerleitung (25) kontaktiert ist und daß die Steuerleitung zwischen den aneinanderliegenden Stirnflächen der beiden Ringe (21, 22) nach außen geführt ist.

7. Halbleiterbauelement nach einem der Ansprüche 1 bis 6, d a d u r c h   g e k e n n z e i c h n e t ,   daß die Öffnung (2) des Bechers (1) auf seiner Innenseite von einer Dichtlippe (19) umgeben ist, und daß einer der Anschlußkörper (3) auf der Dichtlippe (19) aufsitzt.

FIG 1

FIG 2

FIG 3

FIG 4

**Europäisches
Patentamt**

**EUROPÄISCHER RECHERCHENBERICHT**

**0122431**
Nummer der Anmeldung

EP 84 10 2450

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| A | GB-A-1 358 504 (WESTINGHOUSE) <br> * Anspruch 1; Seite 2, Zeilen 62-102; Seite 3, Zeilen 36-52; Figuren 1, 2 * | 1-3,5 | H 01 L 23/04 |
| | --- | | |
| A | Patent Abstracts of Japan Band 5, Nr. 91, 13. Juni 1981 & JP-A-56-35440 | 1-3 | |
| | --- | | |
| A | Patent Abstracts of Japan Band 5, Nr. 91, 13. Juni 1981 & JP-A-56-35442 | 1-3 | |
| | --- | | |
| A | Patent Abstracts of Japan Band 6, Nr. 87, 25. Mai 1982 & JP-A-57-23249 | 1-3 | |
| | --- | | RECHERCHIERTE SACHGEBIETE (Int. Cl. ³) |
| A,D | EP-A-0 034 208 (R. BOSCH) <br> * Anspruch 1; Figur * | 1 | H 01 L 23/04 |
| | ----- | | |

Der vorliegende Recherchenbericht wurde für alle Patentansprüche erstellt.

| Recherchenort <br> BERLIN | Abschlußdatum der Recherche <br> 28-05-1984 | Prüfer <br> ROTHER A H J |
|---|---|---|

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, überein-stimmendes Dokument

EPA Form 1503. 03.82